# EUROPEAN PATENT APPLICATION

(11) **EP 4 738 647 A1**
(43) Date of publication of application: **06.05.2026**
(21) Application number: 24868410.2
(22) Date of filing: 03.05.2024
(51) Int. Cl.: H02J 50/00, H02J 50/20, H02J 7/00, G06F 1/16, G06F 1/3215, H05K 1/18, F16H 19/04, H02J 50/90

(54) **WEARABLE DEVICE AND ELECTRONIC DEVICE FOR CHARGING SAME**

(30) Priority: 19.09.2023 KR 20230125164; 01.11.2023 KR 20230149503
(71) Applicant: Samsung Electronics Co., Ltd., Suwon-si, Gyeonggi-do 16677 (KR)
(72) Inventor: KIM, Hongki, Suwon-si, Gyeonggi-do 16677 (KR)
(74) Representative: Gulde & Partner
(86) International application number: PCT/KR2024/006026
(87) International publication number: WO 2025/063423

(57) **Abstract**

An electronic device for charging a wearable device, according to an embodiment, may comprise: a housing including a first region for mounting a wearable device and a second region surrounding the first region; a support structure on the first region, the support structure being configured to supply power to the wearable device and including a first supporting part movable with respect to the housing and a second supporting part opposite to the first supporting part; and a control structure coupled to the support structure. In order to fix the wearable device onto the first region through the first supporting part and the second supporting part, the control structure may be configured to adjust the spacing between the first supporting part and the second supporting part by moving the first supporting part with respect to the housing.

## Description

### [Technical Field]

The disclosure relates to a wearable device and an electronic device for charging the wearable device.

### [Background Art]

Wearable devices(for example, a smart ring) may be used in a state worn on a part of a user's body. Wearable devices may be provided with various types of products. For example, a wearable device may include a ring-shaped apparatus for being worn on a part of the user's body. The wearable device may be provided to the user in various sizes to meet the user's needs. In an electronic device (e.g., a charger) for charging the wearable device, a structure for charging the wearable device provided in various sizes may be required.

The above information may be presented as related arts only to assist with an understanding of the disclosure. No determination has been made, and no assertion is made, as to whether any of the aforementioned might be applicable as a prior art with regard to the disclosure.

### [Disclosure]

### [Technical Solution]

According to an embodiment, an electronic device for charging a wearable device may include a housing including a first region for mounting the wearable device, and a second region surrounding the first region. The electronic device may include a support structure disposed on the first region and configured to supply power to the wearable device, wherein the support structure includes a first supporting part movable with respect to the housing and a second supporting part facing the first supporting part. The electronic device may include a control structure coupled with the support structure. The control structure may be configured to adjust a distance between the first supporting part and the second supporting part by moving the first supporting part with respect to the housing to fasten the wearable device on the first region through the first supporting part and the second supporting part.

According to an embodiment, a wearable device may include a frame including a first surface configured to face a part of a user's body while the wearable device is worn by the user and a second surface opposite to the first surface. The wearable device may include a sensor including a light emitter facing the first surface and a light receiver configured to receive at least a portion of light emitted from the light emitter, and at least one processor. The wearable device may include memory, comprising one or more storage mediums, storing instructions. The instructions, when executed by the at least one processor individually or collectively, may cause the wearable device to obtain information related to an external environment through the at least a portion of the light emitted from the light emitter and received by the light receiver. The instructions, when executed by the at least one processor individually or collectively, may cause the wearable device to identify whether the wearable device is mounted on an electronic device configured to charge the wearable device, based on at least a portion of the information. The instructions, when executed by the at least one processor individually or collectively, may cause the wearable device to perform a charging mode of the wearable device, based on identifying that the wearable device is mounted on the electronic device.

According to an embodiment, an electronic device for charging a wearable device may include a housing including a first region for mounting the wearable device and a second region surrounding the first region. The electronic device may include a support structure disposed on the first region and configured to supply power to the wearable device, wherein the support structure including a first supporting part and a second supporting part facing the first supporting part and including at least one groove recessed toward the first supporting part. The first supporting part may be movable with respect to the housing, for fastening the wearable device onto the first region. The color of the support structure may be different from the color of the housing.

### [Description of Drawings]

FIG. 1 is a block diagram of an electronic device in a network environment according to an embodiment.
FIG. 2A illustrates an example wearable device.
FIG. 2B is a cross-sectional view of an example wearable device.
FIGS. 3A and 3B illustrates an example electronic device for charging an example wearable device.
FIG. 3C illustrates a part of an example electronic device on which a wearable device is mounted.
FIGS. 4A, 4B, and 4C illustrate an electronic device for charging an example wearable device.
FIG. 5A illustrates an example wearable device mounted on an electronic device.
FIG. 5B illustrates an example wearable device worn by a user.
FIG. 6 is a graph indicating the light quantity measured by a sensor of an example wearable device according to a state of the wearable device.
FIGS. 7A and 7B are a flowchart of operations of a processor of an example wearable device.
FIG. 8 is a flowchart of operations of a processor of an example wearable device.

### [DETAILED DESCRIPTIONS]

The terms as used in the disclosure are provided to merely describe specific embodiments, not intended to limit the scope of other embodiments. Singular forms include plural referents unless the context clearly dictates otherwise. The terms and words as used herein, including technical or scientific terms, may have the same meanings as generally understood by those skilled in the art. The terms as generally defined in dictionaries may be interpreted as having the same or similar meanings as or to contextual meanings of the relevant art. Unless otherwise defined, the terms should not be interpreted as ideally or excessively formal meanings. Even though a term is defined in the disclosure, the term should not be interpreted as excluding embodiments of the disclosure under circumstances.

The term "couple" and the derivatives thereof refer to any direct or indirect communication between two or more elements, whether or not those elements are in physical contact with each other. The terms "transmit", "receive", and "communicate" as well as the derivatives thereof encompass both direct and indirect communication. The terms "include" and "comprise", and the derivatives thereof refer to inclusion without limitation. The term "or" is an inclusive term meaning "and/or". The phrase "associated with," as well as derivatives thereof, refer to include, be included within, interconnect with, contain, be contained within, connect to or with, couple to or with, be communicable with, cooperate with, interleave, juxtapose, be proximate to, be bound to or with, have, have a property of, have a relationship to or with, or the like. The term "controller" refers to any device, system, or part thereof that controls at least one operation. The functionality associated with any particular controller may be centralized or distributed, whether locally or remotely. The phrase "at least one of," when used with a list of items, means that different combinations of one or more of the listed items may be used, and only one item in the list may be needed.

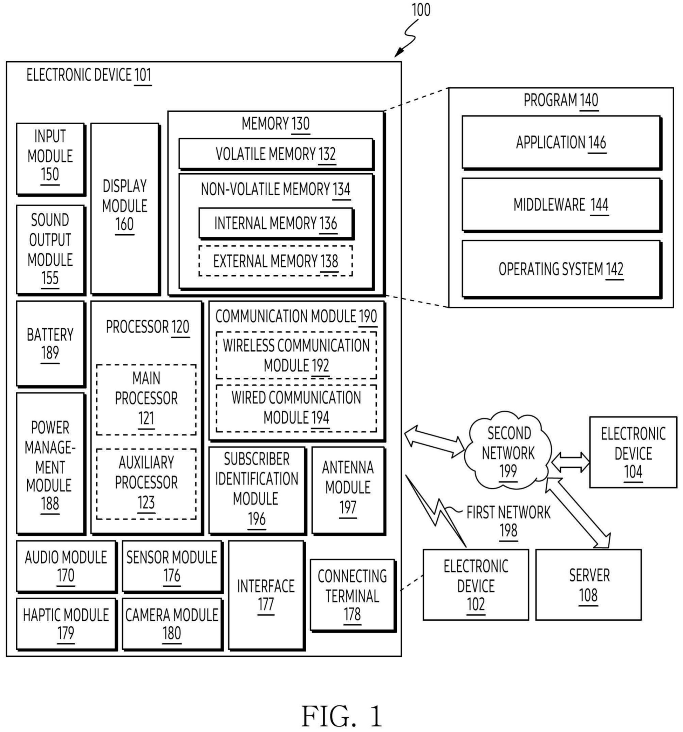

FIG. 1 illustrates a block diagram of an electronic device 101 in a network environment 100 according to an embodiment.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mm Wave band) to address, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form an mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra-low-latency services using, e.g., distributed computing or mobile edge computing. In another example, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

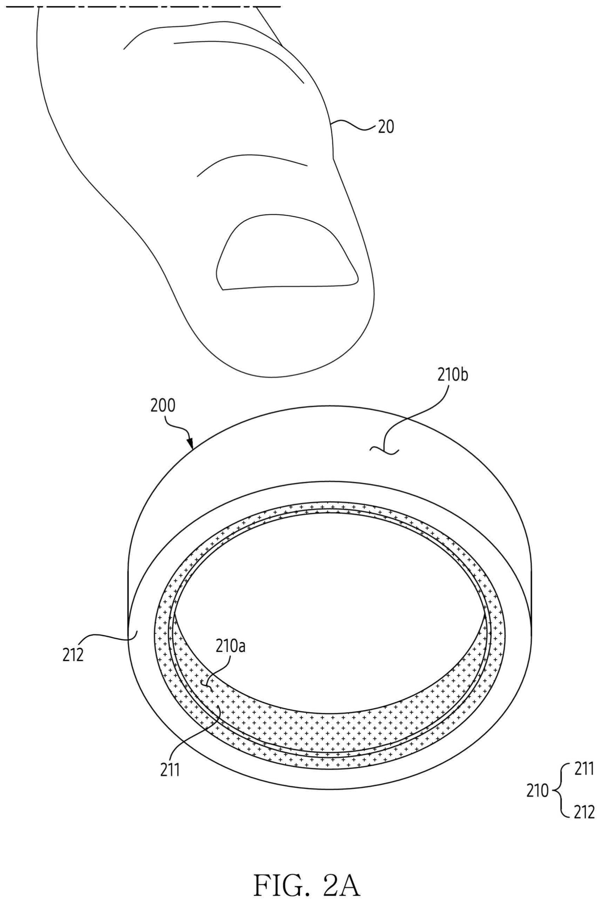

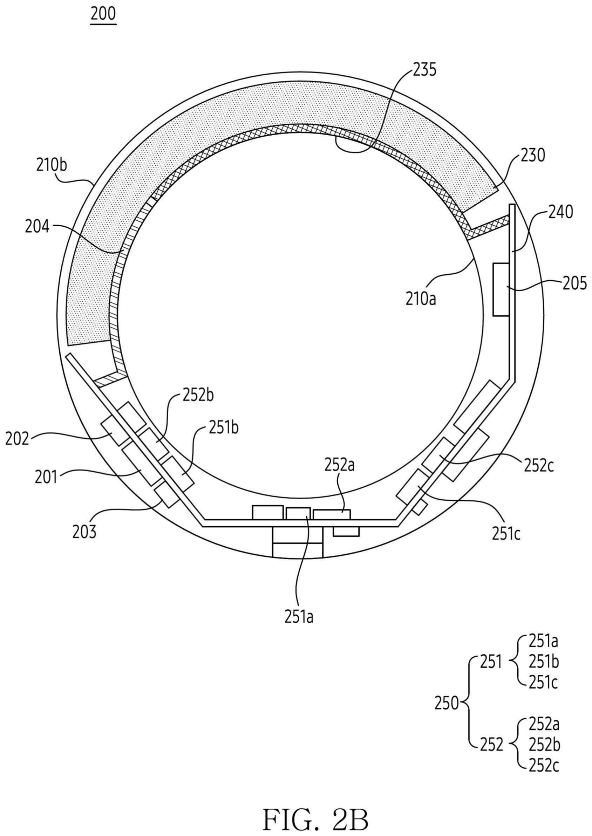

FIG. 2A illustrates an example wearable device. FIG. 2B is a cross-sectional view of an example wearable device.

Referring to FIG. 2A, the wearable device 200 may include a frame 210.

According to an embodiment, the wearable device 200 may be worn by a user (e.g., a person who is wearing the wearable device 200). The wearable device 200 may be worn on a body part 20 of the user. For example, the wearable device 200 may be fastened to the body part 20 of the user. For example, the wearable device 200 may be detachable from the body part 20 of the user.

For example, the wearable device 200 may be worn by the user to be in contact with the body part 20 of the user. For example, the wearable device 200 may be configured to obtain information related to the user through the body part 20 of the user by being worn by the user. For example, the wearable device 200 may provide the user with information indicating a state of the user, based on obtaining the information related to the user. For example, the wearable device 200 may be configured to display information indicating the state of the user through a display of the wearable device 200 and/or an electronic device (e.g., the electronic device 101 of FIG. 1) connected to the wearable device 200, thereby providing the user with the information indicative of the state of the user. The wearable device 200 may be referred to as the electronic device 102 or the electronic device 104 of FIG. 1 in that it provides the user with information related to the user wearing the wearable device 200 via the electronic device 101 connected to the wearable device 200, but the disclosure is not limited thereto.

For example, the body part 20 of the user on which the wearable device 200 is worn may be the user's finger. For example, the frame 210 of the wearable device 200 may have a ring shape, such that the wearable device 200 may be worn on the user's finger. However, the disclosure is not limited thereto. The wearable device 200, which may be referred to as a wearable device, may have a shape corresponding to the body part 20 for being worn on the body part 20 of the user.

According to an embodiment, the frame 210 may include a first surface 210a (e.g., an inner surface) facing the body part 20 of the user while the wearable device 200 is worn on the body part 20 of the user, and a second surface 210b (e.g., an outer surface) opposite to the first surface 210a. The body part 20 may be one of the user's fingers. For example, when the wearable device 200 is worn by the user, at least a portion of the first surface 210a may contact the body part 20 of the user. For example, the first surface 210a may surround the body part 20 of the user wearing the wearable device 200. For example, the first surface 210a may cover the body part 20 of the user wearing the wearable device 200. For example, the first surface 210a may be configured such that the wearable device 200 is fastened to the body part 20 by pressurizing the body part 20 of the user when the wearable device 200 is worn by the user.

For example, the second surface 210b may be an external appearance of wearable device 200 together with the first surface 210a. For example, the second surface 210b may form a ring-shaped frame 210 together with the first surface 210a. For example, the second surface 210b may be a surface spaced apart from the body part 20 of the user, when the electronic device 101 is worn on the body part 20 of the user. For example, while the electronic device 101 is worn on the body part 20 of the user, the first surface 210a may be a surface closest to the body part 20 of the user. The second surface 210b opposite to the first surface 210a may be a surface farthest from the body part 20. For example, the first surface 210a may be referred to as an inner circumferential surface of the frame 210. The second surface 210b opposite to the first surface 210a may be referred to as an outer circumference surface of the frame 210.

Here, the wearable device 200 has been described as being worn on a body part 20 of the user, but the disclosure is not limited thereto. It should be appreciated that the term "body part" is used to describe the body part 20 of the user on which the wearable device 200 is worn and is not intended to limit the body part 20 of the user on which the wearable device 200 is worn or a positional relationship between the body part 20 and the wearable device 200 thereto. For example, the body part 20 may be one of the user's fingers, but is not limited thereto.

According to an embodiment, the frame 210 may include a first frame 211 defining the first surface 210a, and a second frame 212 defining the second surface 210b and coupled to the first frame 211.

For example, the first frame 211 may be a portion of the frame 210 including the first surface 210a. For example, when the wearable device 200 is worn by the user, the first frame 211 may be in contact with the body part 20 of the user. For example, referring to FIG. 2B together, the first frame 211 may provide a medium for a path of light emitted from the light emitter 251. The first frame 211 may include at least one of silicon, epoxy, and acryl, but is not limited thereto.

For example, the second frame 212 may surround the first frame 211. For example, the second frame 212 may support the first frame 211. For example, the second frame 212 may form the outer appearance of the frame 210 together with the first frame 211. For example, the second frame 212 may be a portion of the frame 210 including a second surface 210b opposite to the first surface 210a. The second frame 212 may include at least one of metal and titanium, but is not limited thereto. The frame 210 of the wearable device 200 may include the first frame 211 and the second frame 212 including different materials, thereby providing a user with various user experiences.

Referring to FIG. 2B, the wearable device 200 may include various electronic components in the frame 210 to perform functions of the wearable device 200. For example, the wearable device 200 may include a processor 201, a communication circuit 202, a memory 203, an antenna 204, and a power management circuit 205. The power management circuit 205 may be implemented as at least a part of a power management integrated circuit (PMIC).

In some embodiments, the processor 201 may correspond to two or more processors and the memory 203 may correspond to two or more memories. The processor 201 (at least one processor) may include or correspond to circuitry like a central processing unit (CPU), a microprocessor unit (MPU), an application processor (AP), a communication processor (CP), a system-on-chip (SoC), or an integrated circuit (IC).

According to an embodiment, the wearable device 200 may include a battery 230 for charging the wearable device 200 and a first printed circuit board 240 in the frame 210 connected to the battery 230. For example, the processor 201, the communication circuit 202, the memory 203, and the power management circuit 205 may be mounted on the first printed circuit board 240. The power management circuit 205 may be configured to manage power supplied to the wearable device 200. For example, the battery 230 may include a charging interface 235 connected to the first printed circuit board 240 and configured to receive power from an external power source for charging the battery 230. The battery 230 may be charged with the power supplied through the charging interface 235. The battery 230 may be connected to the first printed circuit board 240 to supply power to at least some of electronic components on the first printed circuit board 240. The first printed circuit board 240 may be at least one of a flexible printed circuit board (FPCB) and a rigid flexible printed circuit board (RFPCB), but is not limited thereto.

According to an embodiment, the antenna 204 and the charging interface 235 may be connected to each other. The antenna 204 and the charging interface 235 may be referred to as a charging antenna and/or a flexible printed circuit board (FPCB) assembly including the charging antenna. For example, the antenna 204 and/or the charging interface 235 may include an RX coil for charging the wearable device 200, but the disclosure not limited to.

The processor 201 may be configured to control at least some of electronic components in the wearable device 200. The processor 201 may control the electronic components in the wearable device 200 through communication with an external electronic device (e.g., the electronic device 101 of FIG. 1) connected to the wearable device 200.

The communication circuit 202 may connect the external electronic device 101 and the wearable device 200. Through the communication circuit 202, the processor 201 may control at least some of the electronic components in the wearable device 200, based on a user input to the external electronic device 101, or may cause an event for executing functions of the external electronic device 101. For example, the processor 201 of the wearable device 200 may be configured to execute an application of the external electronic device 101 through the communication circuit 202 and a processor (e.g., the processor 120 of FIG. 1) in the external electronic device 101. However, the disclosure is not limited thereto.

The electronic components included in the wearable device 200 are not limited to the above-described components. For example, the wearable device 200 may include various sensors such as, for example, a temperature sensor, a proximity sensor, a motion sensor, and a pressure sensor.

According to an embodiment, the wearable device 200 may include a sensor 250 including a light emitter 251 facing the first surface 210a of the frame 210 and a light receiver 252 spaced apart from the light emitter 251, the sensor being configured to detect biometric information about a user.

According to an embodiment, the processor 201 may be configured to emit light using the light emitter 251 of the sensor 250. The processor 201 may be configured to obtain information related to an external environment through at least a portion of the light emitted from the light emitter 251, and then ,received by the light receiver 252, using the light receiver 252 of the sensor 250.

For example, the sensor 250 may be disposed in an inner space of the frame 210 between the first surface 210a and the second surface 210b. For example, the sensor 250 may be disposed on one component (e.g., the first printed circuit board 240) of the wearable device 200 between the first surface 210a and the second surface 210b. The sensor 250 may be electrically connected to the one component. For example, the sensor 250 may be configured to sense a physical state of the user, using the body part 20 of the user wearing the wearable device 200. The wearable device 200 may be configured to provide the user information related to the physical state, based on the sensed state of the user. For example, the sensor 250 may include at least one of an optical sensor or a heartrate measurement (HRM) sensor using photoplethysmography (PPG), but the disclosure is not limited thereto. The light emitter 251 may be referred to as a light emitting diode (LED), and the light receiver 252 may be referred to as a photo diode, but the disclosure is not limited thereto.

For example, the light emitter 251 may be configured to emit light in a plurality of directions. A portion of the light emitted from the light emitter 251 in the plurality of directions may be reflected by the body part 20 of the user wearing the electronic device 101. For example, the light emitter 251 may be configured to emit light toward the body part 20 of the user wearing the wearable device 200. Light emitted from the light emitter 251 toward the body part 20 of the user may be reflected by the body part 20.

For example, the light receiver 252 may be configured to receive a portion of the light emitted in a plurality of directions from the light emitter 251. For example, the light emitter 251 may be configured to emit light toward the body part 20 of the user wearing the electronic device 101. The light receiver 252 may be configured to receive a portion of the light reflected by the body portion 20 of the user. The light receiver 252 may be configured to receive a portion of the light through a space and/or a medium between the first surface 210a and the second surface 210b of the frame 210.

For example, the sensor 250 may be configured to detect the state of the user based on light emitted from the light emitter 251 and then reflected by the body part 20 of the user, being received by the light receiver 252. The electronic device 101 may be configured to obtain information related to the state of the user from the sensor 250. For example, the light emitter 251 may emit light toward the body part 20 of the user wearing the wearable device 200. The light receiver 252 may receive at least a portion of the light emitted from the light emitter 251 and then reflected by the body portion 20. The sensor 250 may be configured to detect the state of the user based on at least a portion of the light reflected by the body part 20.

According to an embodiment, the light emitter 251 may include a plurality of light emitters (251a, 251b, 251c). Each of the plurality of light emitters (251a, 251b, 251c) may be disposed to face the first surface 210a of the frame 210 to emit light toward the body part 20 of the user wearing the wearable device 200. According to an embodiment, the light receiver 252 may include a plurality of light receivers (252a, 252b, 252c). Each of the plurality of light receivers (252a, 252b, 252c) may be disposed to face the first surface 210a of the frame 210 to receive at least a portion of the light emitted from the light emitter 251 and then reflected by the body part 20 of the user wearing the wearable device 200.

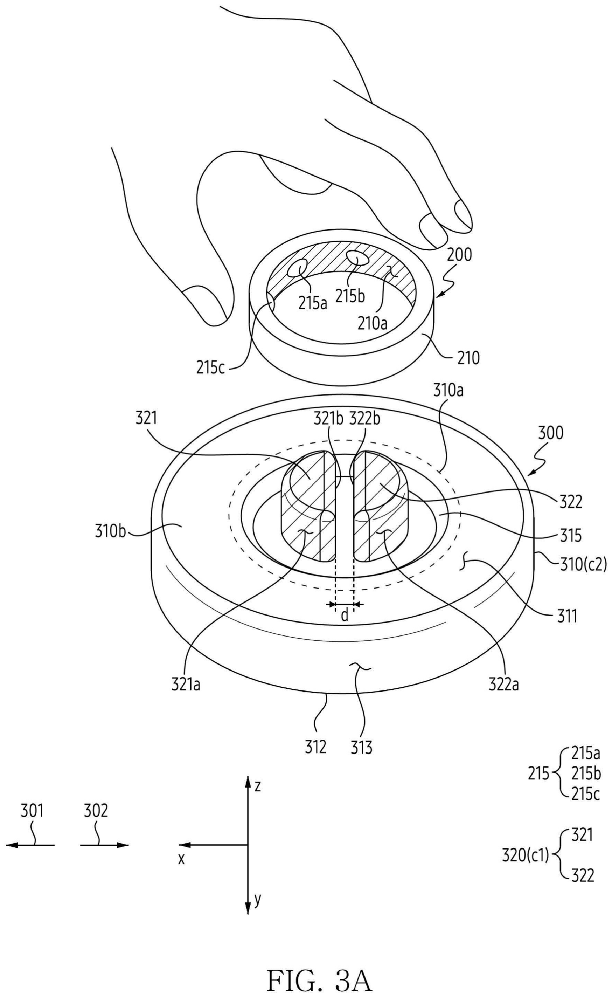

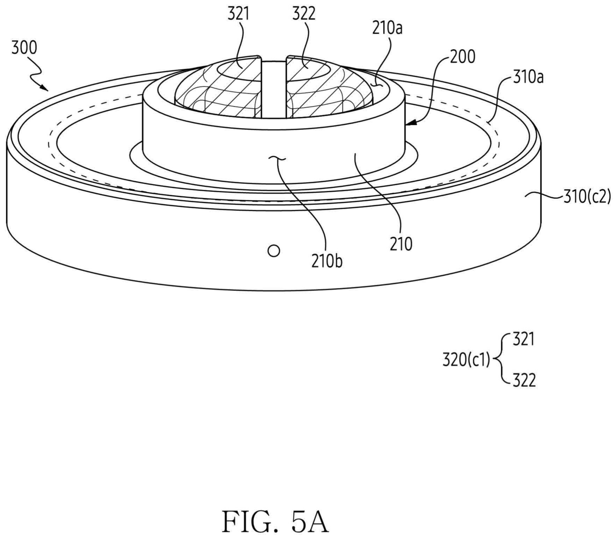

According to an embodiment, in order to reduce power consumption of the wearable device 200, the processor 201 of the wearable device 200 may be required to identify a state in which the wearable device 200 is worn on the body part 20 of the user and a state in which the wearable device 200 is mounted on an electronic device (e.g., an electronic device 300 of FIG. 3A) for charging the wearable device 200. Operation of identifying by the processor 201 whether the wearable device 200 has been mounted on the electronic device 300 for charging the wearable device 200 will be described below with reference to FIG. 5A.

According to an embodiment, the size of the body part 20 of the user wearing the wearable device 200 varies depending on a physical condition of the user wearing the wearable device 200, and therefore, the size of the wearable device 200 having a ring shape and/or the size of the inner circumference of the wearable device 200 may vary accordingly. The electronic device 300 for charging the wearable device 200 may require a changeable structure in accordance with the size of the wearable device 200 that varies depending on the size of the body part 20 of the user. Such changeable structure of the electronic device 300 will be described below with reference to FIG. 3A.

According to the above-described embodiment, the wearable device 200 may be worn on the body part 20 of the user to provide the user with a variety of user experiences. The wearable device 200 may be configured to include the frame 210 having the first surface 210a configured to face the body part 20 of the user, thereby improving the wearing comfort of the user and providing the user with information related to the state of the user.

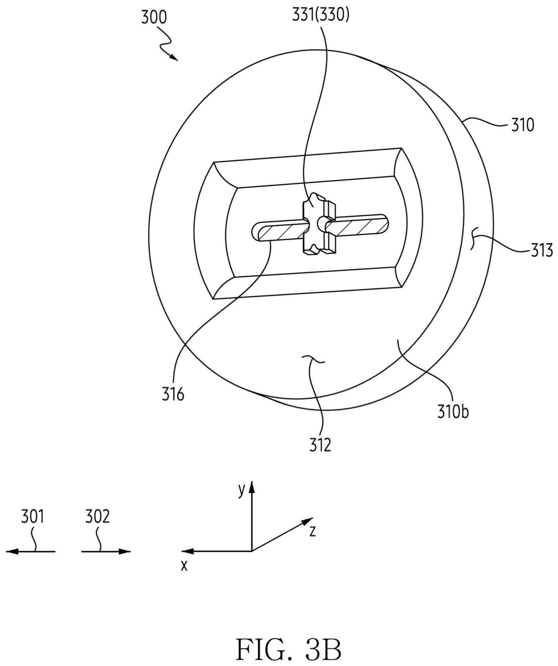

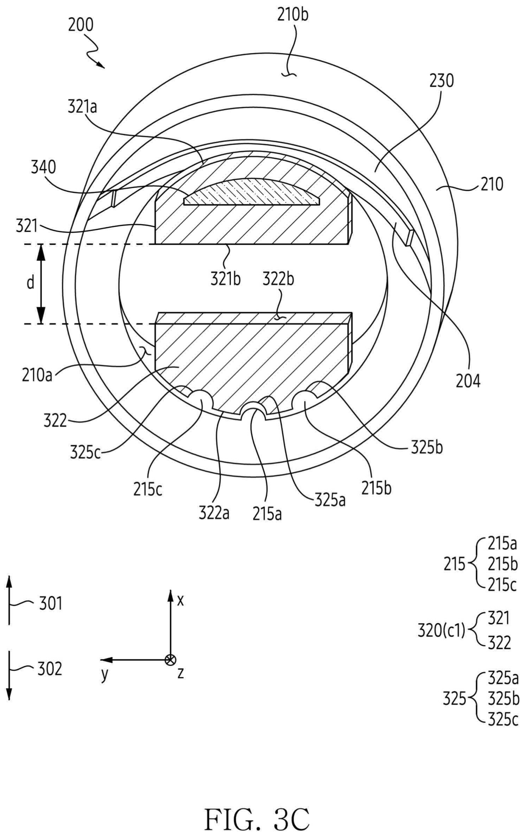

FIGS. 3A and 3B illustrate an example electronic device for charging an example wearable device. FIG. 3C illustrates a part of the electronic device on which the wearable device is mounted.

Referring to FIGS. 3A, 3B, and 3C, an electronic device 300 for charging a wearable device 200 may include a housing 310, a support structure 320, and a control structure 330.

According to an embodiment, the electronic device 300 may include the housing 310, a first region 310a, and a second region 310b surrounding the first region 310a. For example, the first region 310a may be a region where the wearable device 200 is placed on. For example, the first region 310a may be a position for charging the wearable device 200. For example, the first region 310a may be a region adapted to fasten the wearable device 200 to the electronic device 300. For example, the second region 310b may be a portion of the housing 310 that extends from the first region 310a. For example, the second region 310b may be a region adapted to support the first region 310a. For example, the second region 310b may be the remaining region of the housing 310 except for the first region 310a. However, the disclosure is not limited thereto.

For example, the housing 310 may include a front surface 311, a rear surface 312 opposite to the front surface 311, and a side 313 between the front surface 311 and the rear surface 312. The first region 310a may include a portion of the front surface 311. The second region 310b may include the remaining portion of the front surface 311, extending from the portion of the front surface 311, the rear surface 312, and the side 313. For example, the front surface 311 may be an upper surface of the housing 310, on which the wearable device 200 is placed. For example, the rear surface 312 may be a surface for supporting the housing 310. However, the disclosure is not limited thereto.

According to an embodiment, the support structure 320 may be disposed on the first region 310a. The support structure 320 may be configured to supply power to the wearable device 200. The support structure 320 may include a first supporting part 321 movable with respect to the housing 310 and a second supporting part 322 facing the first supporting part 321.

For example, the support structure 320 may protrude from the first region 310a of the housing 310. For example, the support structure 320 may be at least partially exposed to the outside of the electronic device 300 through the first region 310a of the housing 310. For example, the support structure 320 may be disposed on the front surface 311 of the housing 310 on which the wearable device 200 is mounted. For example, the support structure 320 may include a wireless charging module for charging the wearable device 200 in the support structure 320. For example, the support structure 320 may be disposed to be in contact with the electronic device 300 mounted on the first region 310a or to be adjacent to the electronic device 300, thereby supplying power to the wearable device 200 using wireless charging. For example, the support structure 320 may include an antenna 340 for the wireless charging. The wearable device 200 may receive power from the electronic device 300 to the battery 230 of the wearable device 200 through the antenna 340 and the antenna 204 in the wearable device 200.

For example, the antenna 340 may be referred to as a TX antenna configured to interact with the antenna 204 (or the charging interface 235) in the wearable device 200 corresponding to an RX coil. The antenna 340 may be, for example, attached to an inside of the first supporting part 321. The antenna 340 may be a part of the flexible printed circuit board 420. Since the antenna 340 is attached to the inside of the first supporting part 321 through a structure (e.g., a groove) inside the first supporting part 321, the antenna 340 may be configured to charge the wearable device 200 through the antenna 204 and/or the charging interface 235 inside the wearable device 200. The antenna 340 may be, for example, formed of a conductive pattern in the printed circuit board 420, but is not limited thereto.

For example, the first supporting part 321 may be movably coupled with respect to the housing 310. For example, the first supporting part 321 may be slidable with respect to the housing 310 within the first region 310a of the housing 310. For example, the first supporting part 321 may be movable with respect to the housing 310 on the front surface 311 of the housing 310 on which the wearable device 200 is placed. For example, the second supporting part 322 may be coupled to the housing 310 to face the first supporting part 321 in the first region 310a. For example, the second supporting part 322 may be configured to be in contact with the first supporting part 321 that moves with respect to the housing 310 or to be spaced apart from the first supporting part 321. For example, the second supporting part 322 may have a shape substantially the same as or similar to that of the first supporting part 321, but is not limited thereto. The support structure 320 may have a movable first supporting part 321 such that a distance 'd' between the first supporting part 321 and the second supporting part 322 may be adjustable for enabling charging of the wearable device 200 of various sizes.

For example, the first supporting part 321 may be movable in a first direction 301 with respect to the housing 310 and a second direction 302 opposite to the first direction 301. For example, the first support part 321 may move away from the second supporting part 322 by moving in the first direction 301. The first supporting part 321 may move in the second direction 302 opposite to the first direction 301 to get closer to the second supporting part 322. As the first supporting part 321 moves away from the second supporting part 322, the size of the wearable device 200, capable of being mounted on the first region 310a by the first supporting part 321 and the second supporting part 322, may increase. As the first supporting part 321 approaches the second supporting part 322, the size of the wearable device 200, capable of being mounted on the first region 310a by the first supporting part 321 and the second supporting part 322, may decrease.

According to an embodiment, the control structure 330 may be coupled with the support structure 320. For example, the control structure 330 may be at least partially exposed to the outside of the electronic device 300 through the second region 310b. For example, the control structure 330 may be manipulated by the user of the electronic device 300 to move the first supporting part 321 with respect to the housing 310.

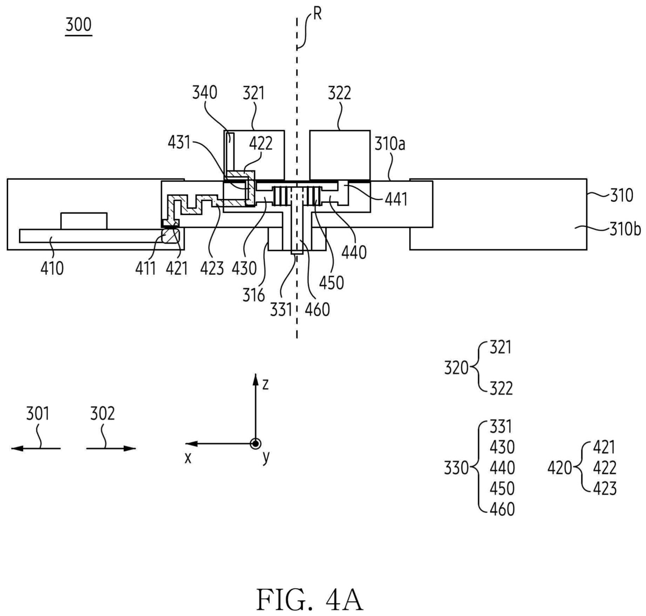

For example, the control structure 330 may be at least partially disposed on the rear surface 312 opposite to the front surface 311 on which the support structure 320 is disposed. For example, the housing 310 may include a first guide hole 316 formed in the second region 310b. The control structure 330 may include a guide structure 331 that is movable with respect to the housing 310 through the first guide hole 316. The guide structure 331 may be configured to move the first supporting part 321 with respect to the housing 310 by moving with respect to the housing 310. For example, the first guide hole 316 may extend in a direction substantially parallel to the x-axis. The guide structure 331 may be movable, along the first guide hole 316, in the first direction 301 parallel to the x-axis and the second direction 302 opposite to the first direction 301. The guide structure 331 may move in the first direction 301 and the second direction 302 so as to move the first supporting part 321 in the first direction 301 and the second direction 302. With regard to the control structure 330 and the guide structure 331 moving the first supporting part 321, it will be described later with reference to FIG. 4A and its subsequent diagrams.

According to an embodiment, the control structure 330 may be configured to move the first supporting part 321 relative to the housing 310, in order to fix the wearable device 200 onto the first region 310a through the first supporting part 321 and the second supporting part 322.

The expression such as e.g., "~ fasten the wearable device 200 on the first region 310a of the electronic device 300" is intended to represent that the wearable device 200 is not easily movable with respect to the first region 310a, and in addition to the term "~ fasten to", other terms such as "settle", "stick", "tighten", "attach", "fix", "hold", " be coupled to", "connect", "tie", or the like having the equivalent technical meaning may be used in substitution, and therefore, it is not intended to limit the relationship of arrangement between the two corresponding components thereto.

For example, the wearable device 200 may include the frame 210 including the first surface 210a facing a body part (e.g., the body part 20 of FIG. 2A) of the user while being worn by the user, and the second surface 210b opposite to the first surface 210a. The first surface 210a may face the support structure 320 while the wearable device 200 is placed on the first region 310a of the electronic device 300. The control structure 330 may be configured to adjust the distance 'd' between the first supporting part 321 and the second supporting part 322 by moving the first supporting part 321 of the support structure 320 with respect to the housing 310. The control structure 330 may be configured such that the first supporting part 321 and the second supporting part 322 come into contact with the first surface 210a by adjusting the distance 'd' between the first supporting part 321 and the second supporting part 322. The first supporting part 321 and the second supporting part 322 may fix the wearable device 200 to the housing 310 of the electronic device 300 by pressing the first surface 210a. The support structure 320 may be configured to fix the wearable device 200 to the housing 310, thereby reducing separation of the wearable device 200 from the electronic device 300, while the wearable device 200 is charged through the electronic device 300.

According to an embodiment, the first supporting part 321 may include an antenna 340 for wireless charging of the wearable device 200. For example, the antenna 340 may be disposed in the first supporting part 321. For example, the antenna 340 may be disposed to face the first surface 210a of the wearable device 200, while the wearable device 300 is mounted on the first region 310a. For example, the antenna 340 may be disposed along one surface (e.g., a first curved surface 321a) of the first supporting part 321 configured to face the first surface 210a of the wearable device 200. The electronic device 300 may be configured to charge the wearable device 200 of various sizes through the first supporting part 321 movable with respect to the housing 310, because the antenna 340 is included in the first supporting part 321.

According to an embodiment, the first supporting part 321 may include the first curved surface 321a configured to face the wearable device 200 mounted on the first region 310a. The second supporting part 322 may include a second curved surface 322a configured to face the wearable device 200 mounted on the first region 310a, and at least one groove 325 recessed toward the first supporting part 321 from the second curved surface 322a.

For example, the first curved surface 321a of the first supporting part 321 and the second curved surface 322a of the second supporting part 322 may have a shape corresponding to the first surface 210a of the wearable device 200 to support the wearable device 200 mounted on the first region 310a. For example, a direction (e.g., the first direction 301) in which the first curved surface 321a faces may be opposite to a direction (e.g., the second direction 302) in which the second curved surface 322a faces. For example, the first curved surface 321a may be a surface configured to come into contact with the wearable device 200 of the first supporting part 321. The second curved surface 322a may be a surface configured to come into contact with the wearable device 200 of the second supporting part 322.

For example, the at least one groove 325 may be configured to face the first surface 210a of the wearable device 200 mounted on the first region 310a. For example, the first supporting part 321 may include a first plane 321b facing the second supporting part 322. The second supporting part 322 may include a second plane 322b facing the first supporting part 321. The first plane 321b and the second plane 322b may be configured to contact or be spaced apart from each other as the first supporting part 321 moves with respect to the housing 310. The at least one groove 325 may be recessed from the second curved surface 322a of the second supporting part 322 toward the second plane 322b.

For example, the wearable device 200 may include a sensor (e.g., the sensor 250 of FIG. 2B) including a light emitter (e.g., the light emitter 251 of FIG. 2B) and a light receiver (e.g., the light receiver 252 of FIG. 2B). The wearable device 200 may include at least one protrusion 215 disposed on the sensor 250 and protruding from the first surface 210a, adapted to improve the performance of the sensor 250. The at least one groove 325 of the second supporting part 322 may have a shape corresponding to the shape of the at least one protrusion 215, thereby guiding the position of the wearable device 200 such that the at least one protrusion 215 is seated in the at least one groove 325, when the wearable device 200 is mounted on the first region 310a. For example, the at least one groove 325 may include a plurality of grooves 325a, 325b, 325c. The at least one protrusion 215 of the wearable device 200 may include a plurality of protrusions 215a, 215b, 215c. The plurality of grooves 325a, 325b, 325c may be configured to be coupled to the plurality of protrusions 215a, 215b, 215c, respectively, while the wearable device 200 is mounted on the first region 310a.

For example, the second supporting part 322 may include the at least one groove 325 to guide the position of the wearable device 200 for charging the wearable device 200 through the electronic device 300. For example, the antenna 204 and the battery 230 for charging in the wearable device 200 may be configured to face at least one protrusion 215 of the wearable device 200. The at least one groove 325 may guide the at least one protrusion 215 to be positioned in the at least one groove 325, thereby guiding the wearable device 200 such that the first supporting part 321 including the antenna 340 for wireless charging and facing the second supporting part 322 is adjacent to the antenna 204 and the battery 230.

According to an embodiment, the second supporting part 322 may be movably coupled to the housing 310 by the control structure 330. For example, the second supporting part 322 may be movable with respect to the housing 310 together with the first supporting part 321. For example, the second supporting part 322 may be coupled to the first region 310a of the housing 310 so as to be movable in the first direction 301 with respect to the housing 310 and the second direction 302 opposite to the first direction 301. For example, the second supporting part 322 may be configured to move in the second direction 302 opposite to the first direction 301 with respect to the housing 310 by the control structure 330, while the first supporting part 321 moves in the first direction 301 with respect to the housing 310. The second supporting part 322 may be configured to move in the first direction 301 by the control structure 330, while the first supporting part 321 moves in the second direction 302. However, the disclosure is not limited thereto. The support structure 320 may include a plurality of support portions that are movable with respect to the housing 310. The support structure 320 may be configured to enable charging of the wearable device 200 of various different sizes mounted on the first region 310a, owing to including the plurality of support portions.

According to an embodiment, although not illustrated herein, the electronic device 300 may include a case (not shown) coupled onto the front surface 311 on which the support structure 320 is disposed, so as to cover the support structure 320 and/or the wearable device 200 mounted on the support structure 320. The case may be coupled to the housing 310 so as to be detachable from the housing 310 or to be rotatable with respect to the housing 310 through a connection member (e.g., a hinge). By including the case, the electronic device 300 can reduce dislodging of the wearable device 200 mounted on the housing 310 from the electronic device 300.

Heretofore, the support structure 320 has been described as having the first supporting part 321 and the second supporting part 322, but the disclosure is not limited thereto. For example, the support structure 320 may include three or more support portions movable with respect to the housing 310. For example, the second supporting part 322 of the support structure 320 may be omitted. The support structure 320 may be configured to charge the wearable device 200 of various different sizes mounted on the support structure 320, owing to inclusion of at least one support portion movable with respect to the housing 310.

According to an embodiment, the second supporting part 322 may be fastened to the housing 310. The first supporting part 321 may be coupled to the housing 310 to be movable in the first direction 301 and in the second direction 302 opposite to the first direction 301 with respect to the second supporting part 322. For example, the position of the second supporting part 322 may be fixed with respect to the housing 310. For example, the second supporting part 322 may not be movable relative to the housing 310. For example, the distance d between the first supporting part 321 and the second supporting part 322 may be changed by the first supporting part 321 moving with respect to the second supporting part 322. However, the disclosure is not limited thereto. The support structure 320 may include a plurality of support portions, and at least some of the plurality of support portions may be configured to be movable with respect to the housing 310, thereby enabling charging of the wearable device 200 of various different sizes mounted on the first region 310a.

According to an embodiment, the color 'c1' of the support structure 320 may be different from the color 'c2' of the housing 310. For example, the color of the first supporting part 321 and the color of the second supporting part 322 may be different from the color of the first region 310a in which the first supporting part 321 and the second supporting part 322 are disposed. According to an embodiment, the housing 310 may have a white color, and the support structure 320 may have a black color, but the disclosure is not limited thereto.

The color 'c1' of the support structure 320 has been described above as being different from the color of the housing 310, but the disclosure is not limited thereto. The properties of the support structure 320 may be different from those of the housing 310. For example, the material of the support structure 320 may be different from the material of the housing 310. The color 'c1' of the support structure 320 is different from the color 'c2' of the housing 310, and thus, a variety of user experiences may be provided to the user. The wearable device 200 may be configured to identify whether or not the wearable device 200 is mounted on the electronic device 300 for charging the wearable device 200, by means of the support structure 320 having the color different from that of the housing 310. Such an identification of whether the wearable device 200 is mounted on the electronic device 300 will be described below with reference to FIG. 5A and its subsequent diagrams.

According to an embodiment, the first region 310a may include a seating groove 315 surrounding the support structure 320 and accommodating the wearable device 200. For example, the seating groove 315 may overlap the first region 310a when viewed from above (e.g., when viewed in -z direction). For example, the seating groove 315 may be configured to accommodate the support structure 320. For example, the seating groove 315 may be recessed from the front surface 311 of the housing 310 toward the inside of the housing 310. For example, the seating groove 315 may be configured to guide the first region 310a on the housing 310 for seating the support structure 320 and/or the wearable device 200.

The electronic device 300 for charging the wearable device 200 according to the above-described embodiment may be configured to enable charging of the wearable device 200 having various sizes, by including a support structure 320 including the first supporting part 321 movably coupled with respect to the housing 310 and then antenna 340 for charging the wearable device 200 mounted on the housing 310. The electronic device 300 may include the control structure 330 configured to control movement of the support structure 320, thereby providing the user with a variety of user experiences.

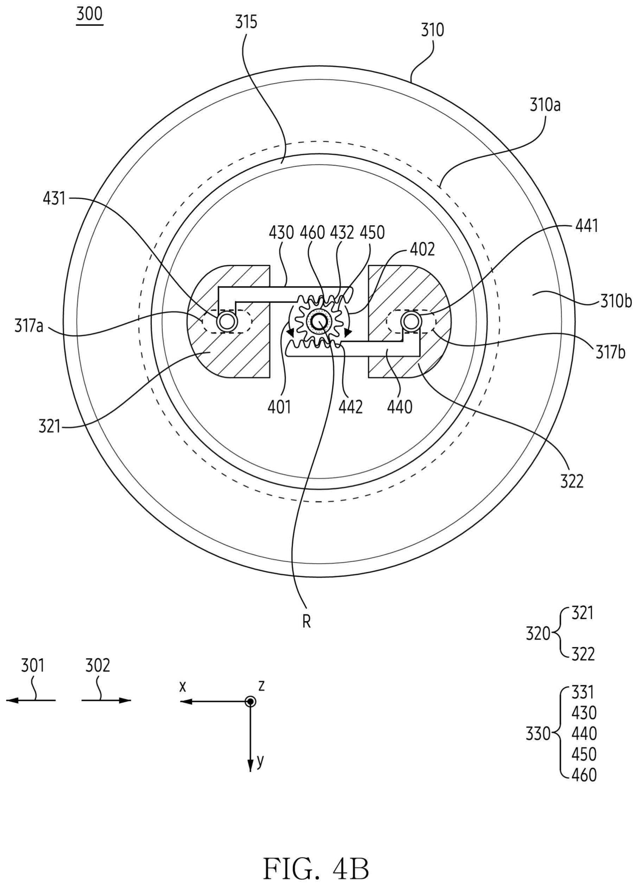

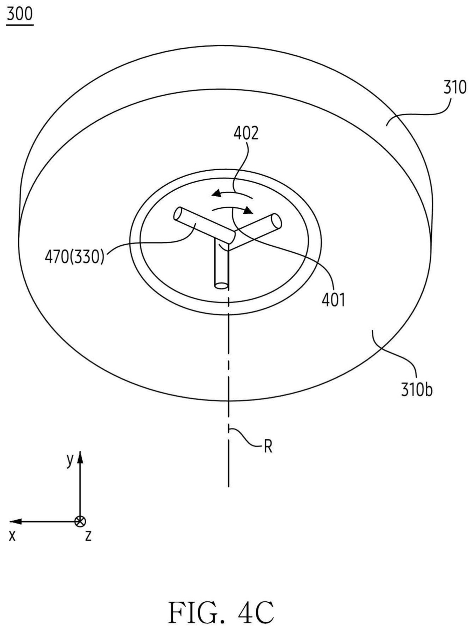

FIGS. 4A, 4B, and 4C illustrate an electronic device for charging an example wearable device.

Referring to FIGS. 4A, 4B, and 4C, the electronic device 300 for charging the wearable device (e.g., the wearable device 200 of FIG. 2A) may include a housing 310 including a first region 310a and a second region 310b surrounding the first region 310a. The electronic device 300 may include a support structure 320 on the first region 310a, configured to supply power to the wearable device 200 mounted on the first region 310a, including a first supporting part 321 movable with respect to the housing 310 and a second supporting part 322 facing the first supporting part 321. The electronic device 300 may include a control structure 330 disposed at least partially on the second region 310b and coupled to the support structure 320 to move the first supporting part 321 with respect to the housing 310. The support structure 320 may be configured to fix the wearable device 200 mounted on the first region 310a to the housing 310 through the first supporting part 321 moved by the control structure 330 and the second supporting part 322.

Hereinafter, redundant descriptions of components having the same reference numerals as those described referring to FIGS. 3A to 3C will be omitted.

According to an embodiment, the first supporting part 321 may include an antenna 340 for wireless charging of the wearable device 200. The electronic device 300 may include a second printed circuit board 410 in the housing 310, and a flexible printed circuit board 420 extending from the antenna 340 to the second printed circuit board 410 to connect the antenna 340 and the second printed circuit board 410.

For example, the second printed circuit board 410 may be disposed between the front surface 311 of the housing 310 and the rear surface 312 opposite to the front surface 311. For example, electronic components of the electronic device may be disposed on the second printed circuit board 410. For example, the second printed circuit board 410 may include a conductive portion 411 to be connected to the flexible printed circuit board 420. The conductive portion 411 may be disposed at one end of the second printed circuit board 410 for connection to the flexible printed circuit board 420, but the disclosure is not limited thereto.

For example, the flexible printed circuit board 420 may electrically connect the antenna 340 in the first supporting part 321 to the second printed circuit board 410. For example, the flexible printed circuit board 420 may include a first portion 421 connected to the second printed circuit board 410, a second portion 422 connected to the antenna 340, and a third portion 423 extending from the first portion 421 to the second portion 422. The first portion 421 and the second portion 422 may have rigidity for connection to the second printed circuit board 410 and the antenna 340, respectively. The third portion 423 may have flexibility for the antenna 340 that moves along the first supporting part 321 movable with respect to the housing 310. However, the disclosure is not limited thereto. The electronic device 300 may be configured to supply power to the wearable device 200 through the antenna 340, by including the flexible printed circuit board 420 connecting the antenna 340 and the second printed circuit board 410. The flexible printed circuit board 420 may be referred to as a rigid flexible printed circuit board in that the flexible printed circuit board 420 includes portions having rigidity, such as the first portion 421 and the second portion 422, but it is not limited thereto.

According to an embodiment, the second supporting part 322 may be movably coupled to the housing 310 by the control structure 330. The control structure 330 may include a first moving member 430 coupled to the first supporting part 321, a second moving member 440 coupled to the second supporting part 322, and a gear 450 in the housing 310. The first moving member 430 may include a first connecting portion 431 connected to the first supporting part 321, and a first gear portion 432. The second moving member 440 may include a second connecting portion 441 connected to the second supporting part 322 and a second gear portion 442. The gear 450 may be engaged with the first gear portion 432 and the second gear portion 442. The first supporting part 321 and the second supporting part 322 may be configured to slide relative to the housing 310, with the movement of the first moving member 430 and the second moving member 440 by rotation of the gear 450.

For example, the housing 310 may include a second guide hole 317a and a third guide hole 317b formed in the first region 310a. The first connecting portion 431 of the first moving member 430 may be coupled to the first supporting part 321 through the second guide hole 317a. The second connection portion 441 of the second moving member 440 may be coupled to the second supporting part 322 through the third guide hole 317b. The first connecting portion 431 may be moved along the second guide hole 317a as the first moving member 430 moves. The second connecting portion 441 may be moved along the third guide hole 317b as the second moving member 440 moves. As the first connecting portion 431 moves, the first supporting part 321 may be moved. As the second connecting portion 441 moves, the second supporting part 322 may be moved.

For example, the first moving member 430 may move the first supporting part 321 in the first direction 301 by the first gear portion 432 as the gear 450 rotates in the first rotation direction 401, and may move the first supporting part 321 in the second direction 302 opposite to the first direction 301 by the first gear portion 432 as the gear 450 rotates in the second rotation direction 402 opposite to the first rotation direction 401. The second moving member 440 may move the second supporting part 322 in the second direction 302 by the second gear portion 442 as the gear 450 rotates in the first rotation direction 401, and may move the second supporting part 322 in the first direction 301 by the second gear portion 442 as the gear 450 rotates in the second rotation direction 402.

For example, while the gear 450 is rotated in the first rotation direction 401 about a rotation axis R, the first moving member 430 may be moved in the first direction 301 by the first gear portion 432 engaged with the gear 450. The first supporting part 321 may be moved in the first direction 301 with respect to the housing 310 along the first moving member 430 moving in the first direction 301. The second moving member 440 may be moved in the second direction 302 opposite to the first direction 301 by the second gear portion 442 engaged with the gear 450. The second supporting part 322 may be moved in the second direction 302 with respect to the housing 310 along the second moving member 440 moving in the second direction 302.

For example, while the gear 450 rotates in the second rotation direction 402 about the rotation axis R, the first moving member 430 may be moved in the second direction 302 by the first gear portion 432 engaged with the gear 450. The first supporting part 321 may be moved in the second direction 302 with respect to the housing 310 along the first moving member 430 moving in the second direction 302. The second moving member 440 may be moved in the first direction 301 opposite to the second direction 302 by the second gear portion 442 engaged with the gear 450. The second supporting part 322 may be moved in the first direction 301 with respect to the housing 310 along the second moving member 440 moving in the first direction 301. The first supporting part 321 and the second supporting part 322 may be configured to be moved in opposite directions to each other by the control structure 330, thereby allowing the wearable device 200 of various different sizes to be fixed onto the housing 310 for charging.

According to an embodiment, the control structure 330 may include a guide structure 331 disposed on the second region 310b, and a shaft 460 configured to extend from the guide structure 331 into the housing 310 to be coupled to the gear 450, providing a rotation axis R to the gear 450.

For example, the shaft 460 may penetrate the gear 450. For example, the shaft 460 may extend from the guide structure 331 to the gear 450. For example, the shaft 460 may penetrate at least a portion of the housing 310. For example, the shaft 460 may be configured to transmit power by a user to the gear 450.

For example, referring to FIG. 3B together, the gear 450 may be coupled to the shaft 460 to rotate about the shaft 460. As the guide structure 331 moves in the first direction 301 along the first guide hole 316, the shaft 460 may be moved in the first direction 301 along the guide structure 331. By the movement of the shaft 460 in the first direction 301, the gear 450 may be rotated in the second rotation direction 402. For example, as the guide structure 331 is moved along the first guide hole 316 in the second direction 302 opposite to the first direction 301, the shaft 460 may move along the guide structure 331 in the second direction 302. By the movement of the shaft 460 in the second direction 302, the gear 450 may be rotated in the first rotation direction 401.

For example, referring to FIG. 4C, the control structure 330 may include a wheel 470 coupled onto the second region 310b so as to be rotatable with respect to the housing 310. The first supporting part 321 may be configured to be moved with respect to the housing 310 by rotation of the wheel 470. For example, the wheel 470 may be coupled onto the second region 310b of the housing 310 so as to be rotated in the first rotation direction 401 with respect to the housing 310 and the second rotation direction 402 opposite to the first rotation direction 401. For example, the wheel 470 may be connected to the shaft 460. For example, the shaft 460 may be fastened to the gear 450. The shaft 460 may rotate the gear 450 in the first rotation direction 401 by rotation of the wheel 470 in the first rotation direction 401. The shaft 460 may rotate the gear 450 in the second rotation direction 402 by rotation of the wheel 470 in the second rotation direction 402 opposite to the first rotation direction 401. The gear 450 may move the first supporting part 321 and/or the second supporting part 322 with respect to the housing 310, by the movement of the first moving member 430 and/or the second moving member 440 by the rotation.

The above-described embodiment is only of an example and the control structure 330 is not limited to those described above, and it should be noted that the control structure 330 may include any structure adapted to move the first supporting part 321 and/or the second supporting part 322. The control structure 330 may be configured to move the first supporting part 321 and/or the second supporting part 322 with respect to the housing 310, such that the wearable device 200 of various sizes mounted on the electronic device 300 for charging can be charged thereon.

According to the above-described embodiment, the electronic device 300 for charging the wearable device 200 may include the control structure 330 configured to move the first supporting part 321 and/or the second supporting part 322, such that the wearable device 200 of different sizes mounted on the electronic device 300 for charging can be charged in place.

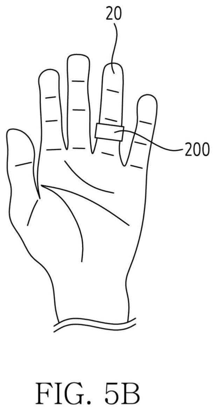

FIG. 5A shows an example wearable device mounted on an electronic device. FIG. 5B illustrates an example wearable device worn by a user.

Referring to FIGS. 5A and 5B, the wearable device 200 may include a frame 210 including the first surface 210a facing a body part 20 of a user while the user wears the wearable device 200, and the second surface 210b opposite to the first surface 210a. The wearable device 200 may include a sensor (e.g., the sensor 250 of FIG. 2B) including a light emitter (e.g., the light emitter 251 of FIG. 2B) facing the first surface 210a and a light receiver (e.g., the light receiver 252 of FIG. 2B) configured to receive at least a portion of light emitted from the light emitter 251, and a processor (e.g., the processor of FIG. 2B). The electronic device 300 for charging the wearable device 200 may include a housing 310 including a first region 310a on which the wearable device 200 is placed, and a support structure 320 including a first supporting part 321 and a second supporting part 322.

According to an embodiment, the processor 201 may be configured to obtain information related to an external environment through at least a portion of the light emitted from the light emitter 251 and received by the light receiver 252. The processor 201 may be configured to identify whether the wearable device 200 is mounted on the electronic device 300 for charging the wearable device 200, based on at least part of the information. For example, the light emitter 251 may be configured to emit light toward the first surface 210a of the frame 210. Since the wearable device 200 is configured such that the first surface 210a of the wearable device 200 surrounds the support structure 320 of the electronic device 300 while it is mounted on the electronic device 300 for charging, at least a portion of the light emitted from the light emitter 251 may be reflected by the support structure 320. The light receiver 252 may receive the at least a portion of the light reflected by the support structure 320. The processor 201 may be configured to identify whether the wearable device 200 is mounted on the electronic device 300, by the at least a portion of the light received by the light receiver 252. For example, since the color 'c1' of the support structure 320 is different from the color 'c2' of the housing 310, the processor 201 may identify the wearable device 200 mounted on the electronic device 300, based on identifying the support structure 320 facing the first surface 210a, through the support structure 320 having the color different from the color of the housing 310. According to an embodiment, the processor 201 may be configured to perform a charging mode of the wearable device 200, based on identifying that the wearable device 200 is mounted on the electronic device 300.

According to an embodiment, the processor 201 may be configured to emit light toward the body part 20 of the user wearing the wearable device 200, using the light emitter 251 of the sensor 250. The processor 201 may be configured to obtain biometric information about the user by receiving at least a portion of the light reflected by the body part 20, using the light receiver 252 of the sensor 250. For example, the processor 201 may control the light emitter 251 to emit light toward the body part 20 of the user while the wearable device 200 is worn on the body part 20 of the user. The light receiver 252 may receive at least a portion of the light emitted from the light emitter 251 and reflected by the body part 20. The processor 201 may obtain biometric information of the user based on the at least a portion of the light reflected by the body part 20.

According to an embodiment, the wearable device 200 may include a power management circuit (e.g., the power management circuit 205 of FIG. 2B). The processor 201 may be configured to bypass power supply to the sensor 250 via the power management circuit 205, based on identifying the wearable device 200 mounted on the electronic device 300 for charging the wearable device 200. For example, based on identifying the light reflected from the support structure 320 of the electronic device 300 and received by the light receiver 252, the processor 201 may control the power management circuit 205 to bypass the power supply to the sensor 250. The wearable device 200 may be configured to bypass the power supply to the sensor 250 while mounted on the electronic device 300, thereby reducing unnecessary power consumption.

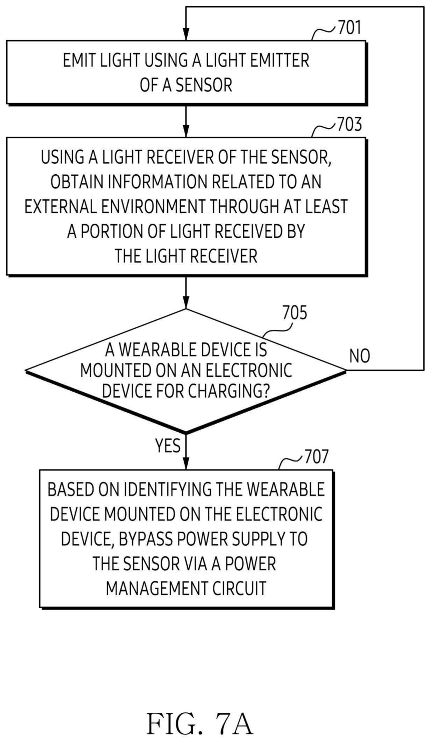

According to an embodiment, the processor 201 may be configured to control the power management circuit 205 to execute a functionality of the wearable device 200 in a first power mode, while identifying that the wearable device 200 is not mounted on the electronic device 300. The processor 201 may be configured to control the power management circuit 205 to execute the functionality of the wearable device 200 in a second power mode that consumes less power than in the first power mode, while identifying that the wearable device 200 is mounted on the electronic device 300. The operation of the processor 201 executing the functionality of the wearable device 200 in the first power mode and the second power mode will be described below with reference to FIG. 7A and its subsequent drawings.

The wearable device 200 according to the above-described embodiment may be configured to identify whether the wearable device 200 is mounted on the electronic device 300 for charging the wearable device 200 or identify whether the user is wearing the wearable device 200, so as to provide the user with various user experiences.

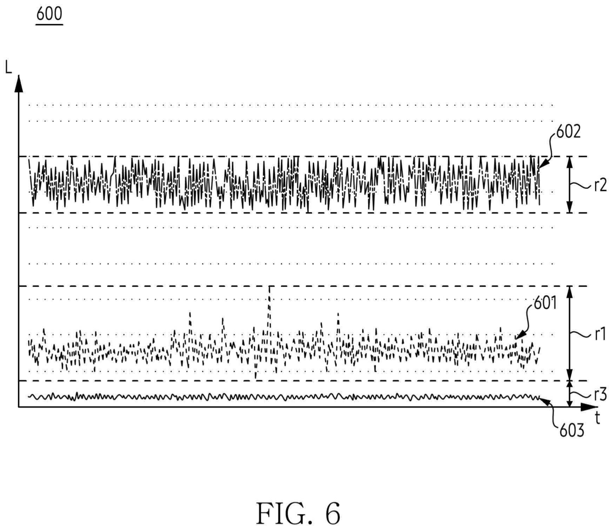

FIG. 6 is a graph indicating the light quantity measured by a sensor of an example wearable device according to a state of the wearable device.

Referring to FIG. 6, the vertical axis of the graph 600 represents the light quantity 'L' measured through a sensor (e.g., the sensor 250 of FIG. 2B) of a wearable device (e.g., the wearable device 200 of FIG. 2A). The light quantity 'L' may be measured by a light receiver (e.g., the light receiver 252 of FIG. 2B) of the sensor 250 receiving at least a portion of light that is emitted from a light emitter (e.g., the light emitter 251 of FIG. 2B) of the sensor 250 and then reflected by an external object (e.g., the body part 20 of FIG. 2A or the support structure 320 of FIG. 3A). The horizontal axis of the graph 600 represents the time. Referring to the graph 600, the light quantity 'L' may vary depending on the external object by which the light emitted from the light emitter 251 is reflected.

According to an embodiment, the processor (e.g., the processor 201 of FIG. 2B) of the wearable device 200 may be configured to identify the light quantity 'L' of at least a portion of the light received by the light receiver 252. The processor 201 may be configured to identify the wearable device 200 mounted on the electronic device 300 for charging the wearable device 200, based on identifying the light quantity 'L' within a first reference range 'r1'. The processor 201 may be configured to identify the wearable device 200 worn on the body part 20 of the user, based on identifying the light quantity 'L' within a second reference range 'r2' different from the first reference range **r1**.

The graph 601 represents the light quantity 'L' received by the light receiver 252 when the wearable device 200 is mounted on the electronic device 300 for charging the wearable device 200. Since the color and/or material of the support structure (e.g., the support structure 320 of FIG. 3A) of the electronic device 300 for charging the wearable device 200 is different from the color and/or material of the housing (e.g., the housing 310 of FIG. 3A) of the electronic device 300, the processor 201 may identify the light quantity 'L' within the first reference range 'r1' through the support structure 320. For example, at least a portion of the light emitted from the light emitter 251 and reflected by the support structure 320 may be received through the light receiver 252. The at least a portion of the light received through the light receiver 252 may have the light quantity 'L' within the first reference range r1.

The graph 602 represents the light quantity 'L' received by the light receiver 252 when the wearable device 200 is worn on a body part of the user (e.g., the body part 20 of FIG. 2A). The processor 201 may identify the light quantity L within the second reference range 'r2' different from the first reference range 'r1', through the body part 20. For example, at least a portion of the light emitted from the light emitter 251 and reflected by the body part 20 of the user wearing the wearable device 200 may be received through the light receiver 252. The at least a portion of the light received through the light receiver 252 may have the light quantity 'L' within the second reference range 'r2'.

The graph 603 represents the light quantity 'L' received by the light receiver 252 when there is no element the first surface (e.g., the first surface 210a of FIG. 2A) of the wearable device 300 faces. The processor 201 may be configured to identify that the wearable device 2000 is in a state of being dislodged from the user, based on identifying the light quantity 'L' within a third reference range 'r3'.

The processor 201 of the wearable device 200 according to the above-described embodiment may be configured to identify whether the wearable device 200 is mounted on the electronic device 300 for charging the wearable device 200, using the light quantity 'L' of the light received by the light receiver 252 of the sensor 250. The wearable device 200 may be configured to identify whether the wearable device 200 is mounted on the electronic device 300, thereby reducing power consumption of the wearable device 200.

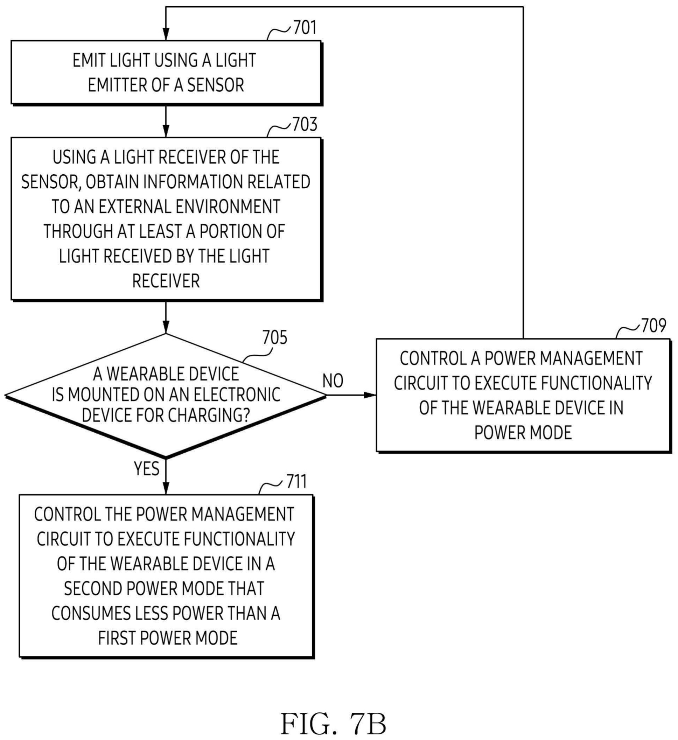

FIGS. 7A and 7B illustrate operations of a processor of an example wearable device.

The operations of FIGS. 7A and 7B may be performed by the processor 201 of FIG. 2B.

In operation 701, the processor 201 may be configured to emit light using the light emitter (e.g., the light emitter 251 of FIG. 2B) of the sensor (e.g., the sensor 250 of FIG. 2B). For example, the processor 201 may control the power management circuit 205 such that the light emitter 251 emits light by supplying power to the sensor 250 via the power management circuit (e.g., the power management circuit 205 of FIG. 2B).

In operation 703, the processor 201 may be configured to obtain information related to an external environment through at least a portion of the light received by the light receiver 252, using the light receiver (e.g., the light receiver 252 of FIG. 2B) of the sensor 250. For example, while the wearable device 200 is mounted on the electronic device (e.g., the electronic device 300 of FIG. 3A) for charging the wearable device 200, the light receiver 252 may receive at least a portion of the light emitted from the light emitter 251 and reflected by a support structure (e.g., the support structure 320 of FIG. 3A) of the electronic device 300. The processor 201 may obtain information related to the electronic device 300 through the at least a portion of the light reflected by the support structure 320.

In operation 705, the processor 201 may be configured to identify whether the wearable device 200 is mounted on the electronic device 300 for charging the wearable device 200. For example, referring to FIG. 6 together, the processor 201 may identify whether the wearable device 200 is mounted on the electronic device 300, using the light quantity 'L' received through the light receiver 252. The processor 201 may control the sensor 250 to cause the light emitter 251 of the sensor 250 to emit light, in response to identifying that the wearable device 200 is not mounted on the electronic device 300.

In operation 707, based on identifying that the wearable device 200 is mounted on the electronic device 300 for charging the wearable device 200, the processor 201 may control the power management circuit 205 to bypass power supply to the sensor 250 via the power management circuit 205. For example, referring to FIG. 6 together, the processor 201 may control the power management circuit 205 to bypass the power supply to the sensor 250 based on identifying the light quantity 'L' within the first reference range 'r1' received by the light receiver 252.

In operation 709 of FIG. 7B, the processor 201 may control the power management circuit 205 to execute the functionality of the wearable device 200 in the first power mode, before identifying that the wearable device 200 is not mounted on the electronic device 300. For example, referring to FIG. 6 together, before identifying the light quantity 'L' within the first reference range 'r1' or the third reference range 'r3' received through the light receiver 252, the processor 201 may control the power management circuit 205 to execute the functionality of the wearable device 200 in the first power mode. The first power mode may be referred to as a normal mode, but is not limited thereto.

In operation 711, after identifying the wearable device 200 mounted on the electronic device 300 for charging the wearable device 200, the processor 201 may control the power management circuit 205 to execute the functionality of the wearable device 200 in the second power mode that consumes less power than the first power mode. For example, referring to FIG. 6 together, after identifying the light quantity 'L' within the first reference range 'r1' received through the light receiver 252, the processor 201 may control the power management circuit 205 to execute the functionality of the wearable device 200 in the second power mode that consumes less power than the first power mode. The second power mode may be referred to as a low power mode and/or a sleep mode, but is not limited thereto.

The processor 201 of the wearable device 200 according to the above-described embodiment may be configured to identify whether it is mounted on the electronic device 300 for charging the wearable device 200, thereby reducing power consumption of the wearable device 200.

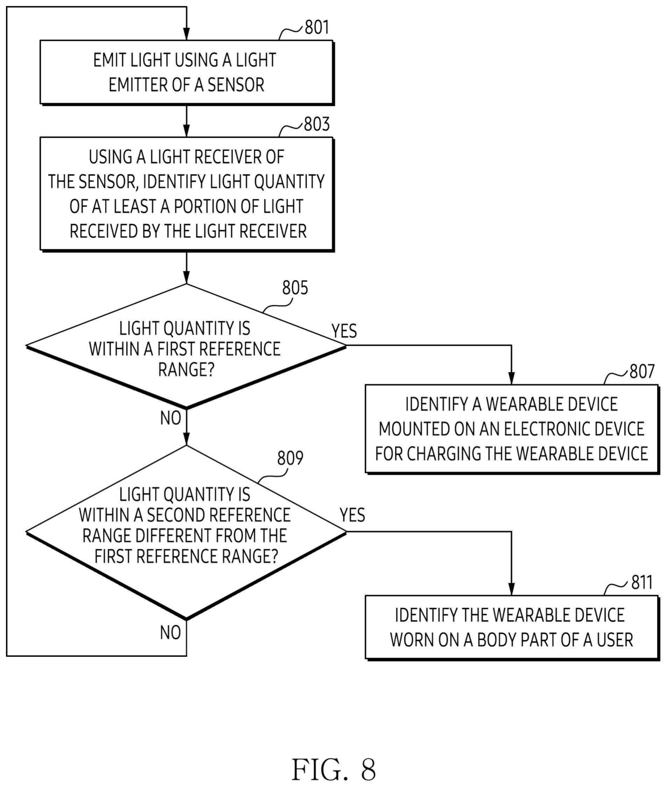

FIG. 8 illustrates an operation of a processor of an example wearable device.

The operation of FIG. 8 may be performed by the processor 201 of FIG. 2B.

Operation 801 of FIG. 8 may correspond to the operation 701 of FIGS. 7A and 7B.

In operation 803, the processor 201 may be configured to identify the light quantity 'L' of at least a portion of the light received by the light receiver 252, using the light receiver (e.g., the light receiver 252 of FIG. 2B) of the sensor (e.g., the sensor 250 of FIG. 2B). For example, the processor 201 may identify a range of the light quantity 'L' of the light received by the light receiver 252 through the light receiver 252 of the sensor 250.

In operation 805, referring to FIG. 6 together, the processor 201 may identify whether at least a portion of the light received through the light receiver 252 is within the first reference range 'r1'. According to an embodiment, the first reference range 'r1' may include a range of the light quantity 'L' greater than the third reference range 'r3' and less than the second reference range 'r2'.

In operation 807, the processor 201 may be configured to identify the wearable device 200 mounted on the electronic device (e.g., the electronic device 300 of FIG. 3A) for charging the wearable device 200, based on identifying the light quantity 'L' within the first reference range 'r1'.

In operation 809, the processor 201 may be configured to identify whether the light quantity 'L' is within the second reference range 'r2' different from the first reference range 'r1', based on identifying that the light quantity 'L' of at least a portion of the light received by the light receiver 252 is not within the first reference range 'r1'. The processor 201 may be configured to emit light using the light emitter 251 of the sensor 250, in response to identifying that the light quantity 'L' is not within the second reference range r2.

In operation 811, the processor 201 may identify the wearable device 200 worn on the user's body part (e.g., the body part 20 of FIG. 2A), based on identifying the light quantity L within the second reference range 'r2'.

The processor 201 of the wearable device 200 may be configured to identify whether the wearable device 200 is mounted on the electronic device 300 for charging the wearable device 200 or to identify whether the user wears the wearable device 200, thereby providing the user with various user experiences.

Technical problems to be addressed in the disclosure are not limited to those mentioned above, and other technical problems not mentioned herein will be apparent to those having ordinary knowledge in the art to which the present disclosure belongs.

According to the above-described embodiment, an electronic device (e.g., the electronic device 300 of FIG. 3A) for charging a wearable device (e.g., the wearable device 200 of FIG. 2A) may include a housing (e.g., the housing 310 of FIG. 3A) including a first region (e.g., the first region 310a of FIG. 3A) for mounting the wearable device, and a second region (e.g., the second region 310b of FIG. 3A) surrounding the first region. The electronic device may include a support structure (e.g., the support structure 320 of FIG. 3A) on the first region, configured to supply power to the wearable device, including a first supporting part (e.g., the first supporting part 321 of FIG. 3A) movable with respect to the housing and a second supporting part (e.g., the second supporting part 322 of FIG. 3A) facing the first supporting part. The electronic device may include a control structure (e.g., the support structure 330 of FIG. 3B) coupled to the support structure. The control structure may be configured to move the first supporting part with respect to the housing for fastening the wearable device onto the first region through the first supporting part and the second supporting part, such that a distance (e.g., the distance d in FIG. 3A) between the first supporting part and the second supporting part facing the first supporting part is adjustable. According to the above-described embodiment, the electronic device may be configured to enable charging the wearable device of various sizes, owing to including the first supporting part movable with respect to the housing. The above-mentioned embodiments may have various different effects in addition to the aforementioned effects.

According to an embodiment, the first supporting part may include an antenna (e.g., the antenna 340 of FIG. 3C) for wireless charging of the wearable device. The electronic device may further include a printed circuit board (e.g., the second printed circuit board 410 of FIG. 4A) in the housing and a flexible printed circuit board (e.g., the flexible printed circuit board 420 of FIG. 4A) extending from the antenna to the printed circuit board to connect the antenna and the printed circuit board. According to the above-mentioned embodiment, the electronic device may be configured to charge the wearable device by including the antenna. The above-mentioned embodiments may provide various effects in addition to the above-mentioned effects.

According to an embodiment, the first supporting part may include a first curved surface (e.g., the first curved surface 321a of FIG. 3A) configured to face the wearable device placed on the first region. The second supporting part may include a second curved surface (e.g., the second curved surface 322a of FIG. 3A) configured to face the wearable device placed on the first region, and at least one groove (e.g., the at least one groove 325 of FIG. 3C) recessed from the second curved surface toward the first supporting part. According to the above-described embodiment, the second supporting part may include the at least one groove to guide a position of the wearable device mounted on the electronic device for wireless charging. The above-described embodiment can provide various other effects in addition to the above-mentioned effects.

According to an embodiment, the second supporting part may be movably coupled with the housing by the control structure. The control structure may include a first moving member (e.g., the first moving member 430 of FIG. 4A) coupled to the first supporting part and including a first gear portion (e.g., the first gear portion 432 of FIG. 4B). The control structure may include a second moving member (e.g., the second moving member 440 of FIG. 4A) coupled to the second supporting part and including a second gear portion (e.g., the second gear portion 442 of FIG. 4B). The control structure may include a gear (e.g., the gear 450 of FIG. 4A) in the housing engaged with the first gear portion and the second gear portion. The first supporting part and the second supporting part may be configured to slide with respect to the housing, by movement of the first moving member and the second moving member by rotation of the gear. According to the above-described embodiment, the control structure may be configured to move the first supporting part and the second supporting part with respect to the housing, by including the first moving member, the second moving member, and the gear. The above-described embodiment can provide various other effects in addition to the above-mentioned effects.

According to an embodiment, the first moving member may move the first supporting part in a first direction (e.g., the first direction 301 of FIG. 3A) by the first gear portion as the gear rotates in a first rotation direction (e.g., the first rotation direction 401 of FIG. 4B), and may move the first supporting part in a second direction (e.g., the second direction 302 of FIG. 3A) opposite to the first direction by the first gear portion as the gear rotates in a second rotation direction (e.g., the second rotation direction 402 of FIG. 4B) opposite to the first rotation direction. The second moving member may move the second supporting part in the second direction by the second gear portion as the gear rotates in the first rotation direction, and may move the second supporting part in the first direction by the second gear portion as the gear rotates in the second rotation direction. According to the above-described embodiment, the control structure may be configured to move the first supporting part and the second supporting part with respect to the housing, by including the first moving member, the second moving member, and the gear. The above-described embodiment can provide various other effects in addition to the above-mentioned effects.

According to an embodiment, the control structure may further include a guide structure (e.g., the guide structure 331 of FIG. 3C) disposed on the second region, and a shaft (e.g., the shaft 460 of FIG. 4A) extending from the guide structure into the housing to be coupled to the gear, and configured to provide a rotation axis (e.g., the rotation axis R of FIG. 4A) to the gear. According to the above-described embodiment, the control structure may be configured to move the first supporting part and the second supporting part with respect to the housing, by including the shaft. The above-described embodiment can provide various other effects in addition to the above-mentioned effects.

According to an embodiment, the control structure may include a wheel (e.g., the wheel 470 of FIG. 4C) coupled to the second region so as to be rotatable with respect to the housing. The first supporting part may be configured to move with respect to the housing by rotation of the wheel. According to the above-described embodiment, the control structure may be configured to move the first supporting part and the second supporting part with respect to the housing, by including the wheel. The above-described embodiment can provide various other effects in addition to the above-mentioned effects.

According to an embodiment, a color (e.g., 'c1' of FIG. 3A) of the support structure may be different from a color (e.g., 'c2' of FIG. 3A) of the housing. According to the above-described embodiment, the color of the support structure may be different from the color of the housing, thereby providing a user with various user experiences. The above-described embodiment can provide various other effects in addition to the above-mentioned effects.

According to an embodiment, the first region may include a seating groove (e.g., the seating groove 315 of FIG. 3A) surrounding the support structure to accommodate the wearable device. According to the above-described embodiment, the housing may include the seating groove to guide a position of the wearable device mounted on the electronic device for charging. The above-described embodiment can provide various other effects in addition to the above-mentioned effects.

According to an embodiment, the second supporting part may be coupled to the housing. The first supporting part may be coupled to the housing to be movable in a first direction and in a second direction opposite to the first direction with respect to the second supporting part. According to the above-described embodiment, the support structure may include the first supporting part movable with respect to the housing to enable charging of the wearable device of various sizes. The above-described embodiment can provide various other effects in addition to the above-mentioned effects.

According to an embodiment, a wearable device may include a frame (e.g., the frame 210 of FIG. 2A) including a first surface (e.g., the first surface 210a of FIG. 2A) facing a body part of a user while wearing the wearable device and a second surface (e.g., the second surface 210b of FIG. 2A) opposite to the first surface. The wearable device may include a sensor (e.g., the sensor 250 of FIG. 2B) including a light emitter (e.g., the light emitter 251 of FIG. 2B) facing the first surface and a light receiver (e.g., the light receiver 252 of FIG. 2B) configured to receive at least a portion of light emitted from the light emitter, and a processor (e.g., the processor 201 of FIG. 2B). The processor may be configured to obtain information related to an external environment through at least a portion of the light emitted from the light emitter and received by the light receiver. The processor may be configured to identify whether the wearable device is placed on the electronic device for charging the wearable device, based at least part of the information. The processor may be configured to perform a charging mode of the wearable device, based on identifying that the wearable device is mounted on the electronic device. According to the above-described embodiment, the processor of the wearable device may be configured to identify whether the wearable device is mounted on the electronic device for charging the wearable device, thereby reducing unnecessary power consumption. The above-described embodiment can provide various other effects in addition to the above-mentioned effects.

According to an embodiment, the processor may be configured to identify a light quantity of the at least a portion of the light received by the light receiver. The processor may be configured to identify the wearable device mounted on the electronic device, based on identifying the light quantity within a first reference range. The processor may be configured to identify the wearable device worn on the body part of the user, based on identifying the light quantity within a second reference range (e.g., **r2** of FIG. 6) different from the first reference range (e.g., **r1** of FIG. 6). According to the above-described embodiment, the processor of the wearable device may be configured to identify whether the wearable device is mounted on the electronic device for charging the wearable device, thereby reducing unnecessary power consumption. The above-described embodiment can provide various other effects in addition to the above-mentioned effects.

According to an embodiment, the wearable device may further include a power management circuit (e.g., the power management circuit 205 of FIG. 2B). The processor may be configured to bypass power supply to the sensor through the power management circuit, based on identifying the wearable device mounted on the electronic device. According to the above-described embodiment, the processor of the wearable device may be configured to identify whether the wearable device is mounted on the electronic device for charging the wearable device, thereby reducing unnecessary power consumption. The above-described embodiment can provide various other effects in addition to the above-mentioned effects.

The wearable device according to an embodiment may further include a power management circuit. The processor may be configured to control the power management circuit to execute a functionality of the wearable device in a first power mode, before identifying that the wearable device is mounted on the electronic device. The processor may be configured to, after identifying that the wearable device is mounted on the electronic device, control the power management circuit to execute the functionality of the wearable device in a second power mode that consumes less power than the first power mode. According to the above-described embodiment, the processor of the wearable device may be configured to identify whether the wearable device is mounted on the electronic device for charging the wearable device, thereby reducing unnecessary power consumption. The above-described embodiment can provide various other effects in addition to the above-mentioned effects.

According to an embodiment, the processor may be configured to emit light toward the body part of the user wearing the wearable device, using the light emitter of the sensor. The processor may be configured to obtain biometric information of the user by receiving at least a portion of the light reflected by the body part, using the light receiver of the sensor. According to the above-mentioned embodiments, the wearable device may be configured to obtain biometric information related to the user through the sensor, thereby providing the user with various user experiences. The above-described embodiment can provide various other effects in addition to the above-mentioned effects.

According to an embodiment, an electronic device for charging a wearable device may include a housing including a first region for mounting the wearable device and a second region surrounding the first region. The electronic device may include a support structure, on the first region, configured to supply power to the wearable device, the support structure including a first supporting part and a second supporting part facing the first supporting part and including at least one groove recessed toward the first supporting part. The first supporting part may be movable with respect to the housing to fix the wearable device onto the first region. A color of the support structure may be different from a color of the housing. According to the above-described embodiment, the electronic device may be configured to enable charging of the wearable device of various sizes, owing to including the first supporting part movable with respect to the housing. The above-described embodiment can provide various other effects in addition to the above-mentioned effects.

According to an embodiment, the first supporting part may include an antenna for wireless charging of the wearable device. The electronic device may further include a printed circuit board in the housing, and a flexible printed circuit board extending from the antenna to the printed circuit board to connect the antenna and the printed circuit board. According to the above-mentioned embodiment, the electronic device may be configured to charge the wearable device, by including the antenna. The above-described embodiment can provide various other effects in addition to the above-mentioned effects.

According to an embodiment, the electronic device may further include a control structure coupled to the support structure. The second supporting part may be movably coupled to the housing by the control structure. The control structure may include a first moving member coupled to the first supporting part and including a first gear portion. The control structure may include a second moving member coupled to the second supporting part and including a second gear portion. The control structure may include a gear in the housing, engaged with the first gear portion and the second gear portion. The first supporting part and the second supporting part may be configured to slide with respect to the housing by movement of the first moving member and the second moving member by rotation of the gear. According to the above-described embodiment, the control structure may be configured to move the first supporting part and the second supporting part with respect to the housing, by including the first moving member, the second moving member, and the gear. The above-described embodiment can provide various other effects in addition to the above-mentioned effects.

According to an embodiment, the first moving member may move the first supporting part in a first direction by the first gear portion, as the gear rotates in a first rotation direction, and may move the first supporting part in a second direction opposite to the first direction by the first gear portion, as the gear rotates in a second rotation direction opposite to the first rotation direction. The second moving member may move the second supporting part in the second direction by the second gear portion, as the gear rotates in the first rotation direction, and may move the second supporting part in the first direction by the second gear portion, as the gear rotates in the second rotation direction. According to the above-described embodiment, the control structure may be configured to move the first supporting part and the second supporting part with respect to the housing, owing to including the first moving member, the second moving member, and the gear. The above-described embodiment can provide various other effects in addition to the above-mentioned effects.

According to an embodiment, the first region may include a seating groove surrounding the support structure to accommodate the wearable device. According to the above-described embodiment, the housing may include the seating groove to guide the position of the wearable device mounted on the electronic device for charging. The above-described embodiment can provide various other effects in addition to the above-mentioned effects.

Effects that are obtainable from the disclosure are not limited to those mentioned above, and other effects not mentioned herein may be clearly understood by those skilled in the art to which the disclosure pertains.

The electronic device according to various embodiments disclosed herein may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may be interchangeably used with other terms, for example, "logic", "logic block", "part", or "circuit". A module may be a single integral component, or a minimum unit or part thereof, adapted to perform one or more functions. For example, according to an example, the module may be implemented in a form of an application-specific integrated circuit (ASIC).

Various embodiments of the present disclosure as set forth herein may be implemented as software (e.g., a program 140) including one or more instructions that are stored in a storage medium (e.g., an internal memory 136 or an external memory 138) that is readable by a machine (e.g., an electronic device 101). For example, a processor (e.g., a processor 120 of an electronic device 101) of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the present disclosure may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (300) for charging a wearable device (200), the electronic device (300) comprising:
a housing (310) including a first region (310a) for mounting the wearable device (200), and a second region (310b) surrounding the first region (310a);
a support structure (320) disposed on the first region (310a) and configured to supply power to the wearable device (200), wherein the support structure (320) includes a first supporting part (321) movable with respect to the housing (310) and a second supporting part (322) facing the first supporting part (321); and
a control structure (330) coupled with the support structure (320),
wherein the control structure (330) is configured to adjust a distance (d) between the first supporting part (321) and the second supporting part (322) by moving the first supporting part (321) with respect to the housing (310), to fasten the wearable device (200) on the first region (310a) through the first supporting part (321) and the second supporting part (322).

2. The electronic device (300) of claim 1, wherein the first supporting part (321) includes an antenna (340) configured to wirelessly charge the wearable device (200), and
wherein the electronic device (300) further comprises:
a printed circuit board (410) in the housing (310); and
a flexible printed circuit board (420) printed circuit board (410) connecting the antenna (340) and the printed circuit board (410) by extending from the antenna (340) to the printed circuit board (410).

3. The electronic device (300) of claim 1 or 2, wherein the first supporting part (321) includes a first curved surface (321a) facing the wearable device (200) placed on the first region (310a), and
wherein the second supporting part (322) includes:
a second curved surface (322a) facing the wearable device (200) placed on the first region (310a); and
at least one groove (325) recessed from the second curved surface (322a) toward the first supporting part (321).

4. The electronic device (300) of any one of claims 1 to 3, wherein the second supporting part (322) is movably coupled with the housing (310) by the control structure (330),
wherein the control structure (330) includes:
a first moving member (430), coupled with the first supporting part (321), including a first gear portion (432);
a second moving member (440), coupled with the second supporting part (322), including a second gear portion (442); and
a gear (450), disposed in the housing (310), engaged with the first gear portion (432) and the second gear portion (442), and
wherein the first supporting part (321) and the second supporting part (322) are configured to slide with respect to the housing (310) through movement of the first moving member (430) and the second moving member (440) by rotation of the gear (450).

5. The electronic device (300) of claim 4, wherein the first moving member (430) is configured to:
move the first supporting part (321) in a first direction (301) by the first gear portion (432) as the gear (450) rotates in a first rotation direction (401), and
move the first supporting part (321) in a first direction (302) opposite to the first direction (301) by the first gear portion (432) as the gear (450) rotates in a second rotation direction (402) opposite to the first rotation direction (401), and
wherein the second moving member (440) is configured to:
move the second supporting part (322) in the first direction (302) by the second gear portion (442) as the gear (450) rotates in the first rotation direction (401), and
move the second supporting part (322) in the first direction (301) by the second gear portion (442) as the gear (450) rotates in the second rotation direction (402).

6. The electronic device (300) of claims 4, wherein the control structure (330) further includes:
a guide structure (331) disposed on the second region (310b); and
a shaft (460) coupled with the gear (450) by extending from the guide structure (331) into the housing (310) and configured to provide a rotation axis (R) to the gear (450).

7. The electronic device (300) of any one of claims 1 to 6,
wherein the control structure (330) includes a wheel (470) coupled on the second region (310b) so as to be rotatable with respect to the housing (310), and
wherein the first supporting part (321) is configured to move relative to the housing (310) by a rotation of the wheel (470).

8. The electronic device (300) of any one of claims 1 to 7, wherein a color (c1) of the support structure (320) is different from a color (c2) of the housing (310).

9. The electronic device (300) of any one of claims 1 to 8, wherein the first region (310a) includes a seating groove (315) surrounding the support structure (320) to accommodate the wearable device (200).

10. The electronic device (300) of any one of claims 1 to 9, wherein the second supporting part (322) is coupled to the housing (310), and
wherein the first supporting part (321) is coupled with the housing (310) movable in a first direction (301) and a first direction (302) opposite to the first direction (301) with respect to the second supporting part (322).

11. A wearable device (200) comprising:
a frame (210) including a first surface (210a) configured to face a part (20) of body of a user while the wearable device (200) is worn by the user and a second surface (210b) opposite to the first surface (210a);
a sensor (250) including a light emitter (251) facing the first surface (210a) and a light receiver (252) configured to receive at least a portion of light emitted from the light emitter (251); and
at least one processor (201); and
memory (203), comprising one or more storage mediums, storing instructions that, when executed by the at least one processor (201) individually or collectively, cause the wearable device (200) to:
obtain information related to an external environment through the at least a portion of the light emitted from the light emitter (251) and received by the light receiver (252);
identify whether the wearable device (200) is placed on an electronic device (300) configured to charge the wearable device (200), based on at least a portion of the information; and
based on identifying that the wearable device (200) is mounted on the electronic device (300), perform a charging mode of the wearable device (200).

12. The wearable device (200) of claim 11, wherein the instructions, when executed by the at least one processor (201) individually or collectively, further cause the wearable device (200) to:
identify a light quantity (L) of the at least portion of the light through the at least portion of the light received by the light receiver (252);
based on identifying the light quantity (L) within a first reference range (r1), identify the wearable device (200) placed on the electronic device (300); and
based on identifying the light quantity (L) within a second reference range (r2) that is different from the first reference range (r1), identify the wearable device (200) worn on the part (20) of body of the user.

13. The wearable device (200) of claim 11 or 12, further comprising a power management circuit (205),
wherein the instructions, when executed by the at least one processor (201) individually or collectively, further cause the wearable device (200) to, based on identifying the wearable device (200) mounted on the electronic device (300), bypass power supply to the sensor (250) through the power management circuit (205).

14. The wearable device (200) of any one of claims 11 to 13, further comprising a power management circuit (205),
wherein the instructions, when executed by the at least one processor (201) individually or collectively, further cause the wearable device (200) to:
before identifying that the wearable device (200) is placed on the electronic device (300), control the power management circuit (205) to execute a functionality of the wearable device (200) in a first power mode; and
after identifying that the wearable device (200) is placed on the electronic device (300), control the power management circuit (205) to execute the functionality of the wearable device (200) in a second power mode that consumes less power than the first power mode.

15. The wearable device (200) of any one of claims 11 to 14, wherein the instructions, when executed by the at least one processor (201) individually or collectively, further cause the wearable device (200) to:
emit light toward the part (20) of body of the user on which the wearable device (200) is worn, using the light emitter (251) of the sensor (250); and
obtain biometric information about the user by receiving at least a portion of the light reflected by the part (20) of body of the user using the light receiver (252).
